# EUROPEAN PATENT SPECIFICATION

(11) **EP 1 253 719 B1**
(45) Date of publication and mention of the grant of the patent: **16.08.2006**
(21) Application number: 01903571.6
(22) Date of filing: 20.01.2001
(51) Int. Cl.: H03L 7/085, H03L 7/093, H04J 3/07, H03L 7/099

(54) **METHOD FOR FILTERING USED IN A DIGITAL PHASE LOCKED LOOP**
FILTERVERFAHREN IN EINER DIGITALEN PHASENREGELSCHLEIFE
PROCEDE DE FILTRAGE MIS EN OEUVRE DANS UNE BOUCLE A VERROUILLAGE DE PHASE NUMERIQUE

(30) Priority: 27.01.2000 CN 00101582
(43) Date of publication of application: 30.10.2002
(73) Proprietor: Huawei Technologies Co., Ltd., Nanshan District, Shenzhen 518057 (CN)
(72) Inventor: HE, Tingbo Huawei service ctr. bldg., Nanshan District Shenzhen 518057 (CN)
(74) Representative: Körber, Martin Hans
(86) International application number: PCT/CN2001/000068
(87) International publication number: WO 2001/059931

(56) References cited:
- EP-A- 0 584 627
- WO-A-97/15118
- US-A- 5 033 064
- US-A- 5 036 294
- US-A- 5 619 543
- US-A- 5 745 001
- US-A- 5 793 824

## Description

### FIELD OF THE INVENTION

The present invention generally relates to digital phase-locked loop (DPLL) frequency synthesizer technology and, more particularly, to a method for controlling the phase and stabilizing the output frequency of a local crystal oscillator clock signal by means of a DPLL frequency synthesizer circuitry.

### BACKGROUND OF THE INVENTION

A phase-locked loop (PLL) frequency synthesizer circuitry is realized as a closed-loop tracking system which is able to track the phase and frequency of a given input signal. When a PLL frequency synthesizer circuitry tracks an input signal with constant frequency, there is no frequency difference. By contrast, when a PLL frequency synthesizer circuitry is used to track an input signal with variable frequency, deviations of an oscillator signal frequency from a given reference frequency are detected and compensated. Thereby, tracking accuracy is very high.

There are two kinds of phase-locked loop circuitries: analog PLL circuitries (APLL) and digital PLL circuitries (DPLL). An APLL frequency synthesizer circuitry consists of a phase detector (PD), a loop filter (LF) as well as a voltage-controlled oscillator (VCO). Compared with a DPLL frequency synthesizer circuitry, an APLL frequency synthesizer circuitry has better vibration suppression performance but features discreteness in technology and involves higher manufacturing costs and lower stability.

If a part of a DPLL frequency synthesizer circuitry is realized as a digital circuit, said DPLL frequency synthesizer circuitry is called partial DPLL circuitry. The herein applied principle is similar to an APLL frequency synthesizer circuitry, and as its frequency control still applies an analog circuitry, a partial DPLL circuitry also implies the drawback of high discreteness, difficulties in manufacturing and high manufacturing costs. In contrast thereto, a so-called all-digital phase-locked loop (DPLL) circuitry is realized by digital circuit elements only.

A new implementation method of a DPLL frequency synthesizer circuitry is disclosed in US 5,033,064. The DPLL frequency synthesizer circuitry implemented by this method features better vibration transfer characteristics and net vibration output characteristics, but there is no effective loop filtering method, and vibration filter performance at lower band frequencies is not ideal.

US 5,793,824 describes a bandwidth-adaptive digital phase locked loop (DPLL)-based clock control arrangement for pulse stuffing a synchronized digital communication system, wherein said DPLL-based clock control arrangement controls the generation of a read-out clock signal which is used for retiming a digital data signal interfaced with a synchronous data channel of said communication system, in which pulse-stuffing synchronization is employed to maintain clock synchronization of the asynchronous digital data signal with a synchronous digital data channel over which the digital data signal is transported. The bandwidth-adaptive digital phase locked loop thereby comprises a loop filter to which an error signal representative of a difference between the asynchronous digital data and a reference clock signal is applied and a phase accumulator which is coupled to the output port of said loop filter and being operative to stepwise adjust the read-out clock signal. The loop filter features a first scaled path having a first, controllably stepped amplification stage as well as a second scaled path having a second, controllably stepped amplification stage coupled to a frequency accumulator. The output signals of the frequency accumulator and said first stepped amplification stage are summed and coupled to the phase accumulator. According to one embodiment of the invention disclosed in US 5,793,824, gain values of each of the first and second amplification stages are incrementally adjusted in accordance with the magnitude of the error signal.

In EP 0 584 627 A2 an incremental phase smoothing desynchronizer and calculation apparatus for desynchronizing data stored within synchronous payload envelopes of a synchronous communication protocol such as SONET (Synchronous Optical Network), said desynchronizer comprising a partial DPLL frequency synthesizer circuitry used for tracking the phase and frequency of an oscillator output signal, is described which provides for smoothing a periodically discontinuous clock signal associated with said data after a synchronous communication protocol overhead has been removed. The desynchronizer accommodates for shifts in the position of said payload envelope and, hence, the data within the synchronous communication frame as well as adjustments within said data itself due to asynchronous bit stuff information. It thereby comprises a leak filter having a linear branch and an integrator branch, both branches having adjustable factors regarding their operation, wherein the adjustable factors are selected depending on threshold values which in turn are based on the difference between an average write address and a read address of an elastic store within which incoming data removed from the aforementioned synchronous communication system frame is temporarily stored. The leak filter constitutes one part of a phase-locked loop which is used for adjusting a read clock frequency in a manner which minimizes overflow or underflow of the elastic store while simultaneously minimizing the changing rate of the read clock rate so as to limit jitter. A fault recovery apparatus constitutes a part of the desynchronizer that is used for enabling a fast lock of high gain factors to quickly adjust said read clock frequency in case an overflow or underflow of the elastic store occurs.

### SUMMARY OF THE INVENTION

The present invention is basically dedicated to a method for controlling the phase ϕ_{*LO*} and stabilizing the output frequency *f*_{*LO*} of a local crystal oscillator clock signal by means of a digital phase-locked loop (DPLL) frequency synthesizer circuitry. Said method is characterized by the steps of defining a phase difference reference value Δϕ_{*ref*} representing a nominal value of the difference Δϕ between the phase ϕ_{*ref*} of an input clock signal and the phase ϕ_{*rec*} of a local recovery clock signal by setting an address difference reference offset *x*₀ representative of said phase difference reference value Δϕ_{*ref*} to half the bit depth *L* of the first-in-first-out memory, calculating a read/write address difference which denotes a bit position difference in a data stream of contents data between an input data pointer and an output data pointer referring to the starting addresses of contents data written to and contents data read from the first-in-first-out memory, respectively, said read/write address difference being representative of a detected phase difference Δϕ between the input clock signal and the local recovery clock signal, comparing the detected phase difference Δϕ with the phase difference reference value Δϕ_{*ref*}, and adjusting the local recovery clock signal in segments to the phase difference reference value Δϕ_{*ref*}, wherein a correction signal *K*(*x*) which is used for adjusting the local recovery clock signal, said correction signal being representative of a change in the detected phase difference Δϕ, is increased or decreased segment by segment depending on the magnitude and the algebraic sign of a detected deviation of the detected phase difference Δϕ from the phase difference reference value Δϕ_{*ref*}.

According to one aspect of the invention, the first-in-first-out memory receives a write address signal and a read address signal, the write address signal being a counter output value representative of the clock frequency of the input clock signal synchronized with a local crystal oscillator clock signal and the read address signal being a further counter output value representative of the clock frequency *f*_{*rec*} of the local recovery clock signal.

According to another aspect of the present invention, said step of adjusting the local recovery clock signal in segments comprises the steps of sampling the detected phase difference Δϕ, calculating increments Δ*K*_{*m*} of a phase accumulator input signal *K*(*x*) that is used for adjusting the phase ϕ_{*rec*} of the local recovery clock signal based on a deviation of a sampled time-domain signal representing the detected phase difference Δϕ from the phase difference reference value Δϕ_{*ref*} such that in case said deviation increases the step size of said increments Δ*K*_{*m*} is set to a larger value, whereas in case said deviation decreases the step size of said increments Δ*K*_{*m*} is set to a smaller value, said increments being a function of the sampled time-domain signal representing the detected phase difference Δϕ, wherein an integer part of the detected phase difference Δϕ is given by the read/write address difference and a digital signal representing the fractional part of the detected phase difference Δϕ is given by a particular increment Δ*K*_{*m*} or by a partial sum of said increments Δ*K*_{*m*}. The aforementioned step of adjusting the local recovery clock signal in segments also comprises the steps of accumulating said increments Δ*K*_{*m*} and calculating said local recovery clock signal by controlling the divider coefficient of a digital frequency divider used for dividing the frequency *f*_{*LO*} of the local crystal oscillator clock signal such that in case said deviation increases an offset rate used for adjusting the phase ϕ_{*rec*} of the local recovery clock signal to the phase ϕ_{*ref*} of the input clock signal is set to a larger value, whereas in case said deviation decreases said offset rate is set to a smaller value, said offset rate being a cumulative function of digital signals being representative of the frequency *f*_{*LO*} of said local crystal oscillator clock signal divided by different divider coefficients stored in the digital frequency divider.

The steps of accumulating said increments Δ*K*_{*m*} and calculating said local recovery clock signal are thereby performed by means of a phase accumulator comprising an adder and a register supplied with a signal being representative of the frequency *f*_{*LO*} of the local crystal oscillator clock signal.

According to a further aspect of the invention, said step of sampling the detected phase difference Δϕ is performed by means of a phase sampling module supplied with a sampling clock signal which is synchronized by the local crystal oscillator clock signal.

According to a still further aspect of the present invention, the phase accumulator input signal *K*(*x*) is a continuous, piecewise linear and strictly monotonously rising function of a digital signal *x*, wherein *x* is given by a function of two further digital signals representing said integer part and said fractional part of the detected phase difference Δϕ, respectively.

According to a still further aspect of the present invention, the bit depth L of the first-in-first-out memory is given by 128 bit and the phase difference reference value Δϕ_{*ref*} is represented by an address difference reference offset x₀ of 64 bit.

Because the invention is based on a DPLL circuitry, it is able to overcome weaknesses of conventional APLL circuitries, which include large dispersion, high cost and low stability. The local recovery clock signal frequency *f*_{*rec*}*,* which is supplied by the digital frequency divider, can adaptively be adjusted according to the detected phase difference Δϕ.

### BRIEF DESCRIPTION OF THE DRAWINGS

In the following description preferred embodiments of the present invention are explained in more detail with reference to the enclosed drawings. Thereby,
- FIG. 1: shows a block diagram of a DPLL circuitry according to the present invention,
- FIG. 2: shows a more detailed view of the block diagram depicted in Fig. 1, and
- FIG. 3: depicts a function diagram showing the input signal *K*(*x*) of the phase accumulator as a function of a digital signal x represented by a function of the integer part and the fractional part of the detected phase difference Δϕ.

### DETAILED DESCRIPTION OF THE PREFERRED EMBODIMENTS

The present invention will now be described in more detail with reference to the accompanying drawings, in which preferred embodiments of the invention are shown. This invention may, however, be embodied in many different forms and should not be construed as limited to the embodiments set forth herein; rather, these embodiments are provided such that the disclosure will be thorough and complete and will fully convey the scope of the invention to those skilled in the art. Thereby, like reference numbers refer to like elements throughout.

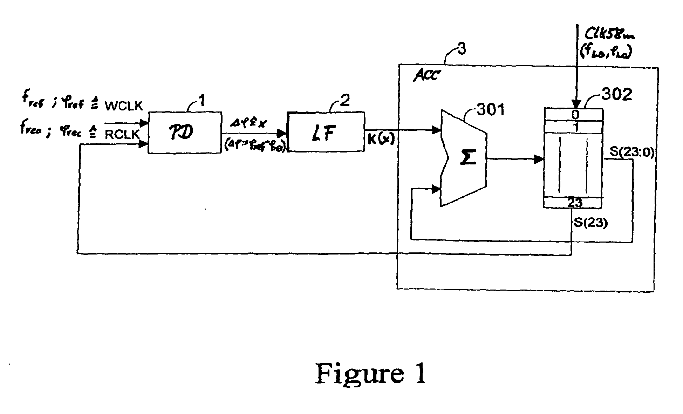

FIG. 1 shows that a DPLL generally comprises a phase detector 1, a loop filter (loop filter) 2 and a phase accumulator 3. The phase detector 1 receives an input clock signal Wclk and a local recovery clock signal Rclk, performs frequency detection and phase detection, and outputs a phase difference Δϕ to the loop filter 2. The loop filter 2 calculates an accumulated frequency signal *K*(*x*) according to a signal x representing the phase difference Δϕ. The phase accumulator 3 comprises an adder 301 and a register 302 which serves as a frequency divider. The adder 301 adds output data S of the register 302 and output data *K* of the loop filter 2, and the register 302 stores the current adding result at every rising clock pulse edge of a local high-speed crystal oscillator signal. Typically, the register has a bit length that equals the adder bit length, and the register only stores a sum without carry bit. The register 302 outputs to the adder 301 an accumulated value *S*(*n*:0)*,* e.g. the result of last adding, such that a cumulative function is implemented. The variable '*n*' herein represents the adder bit length, and the most significant bit (MSB) of the accumulative value is a local recovery clock signal frequency *f*_{*rec*} recovered by the phase accumulator 3 whose output is provided to the phase detector 1 for phase detection. The clock frequency of the phase accumulator 3 is thereby given by the local high-speed crystal oscillator's frequency *f*_{*LO*}*.*

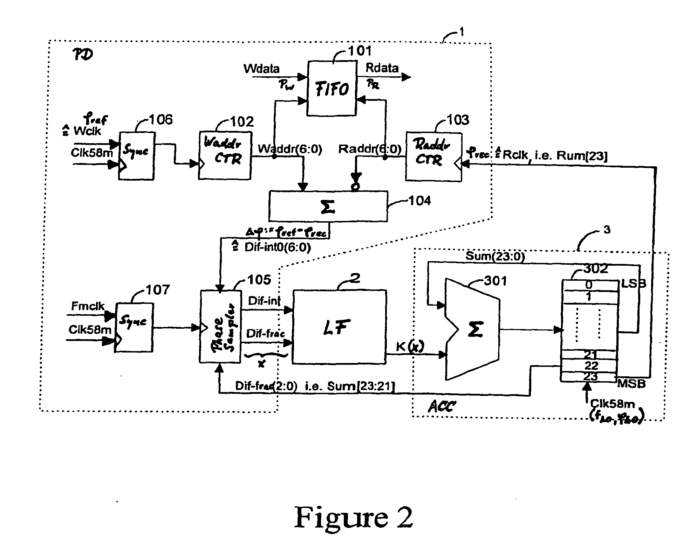

FIG. 2 is a circuit block diagram of an embodiment of the present invention. The circuit applies a local high-speed crystal oscillator providing an oscillator frequency of 58.32 MHz to recover an ideal 2.048 MHz clock with minimized vibration, and the phase accumulator 3 applies a 24-bit adder. The digital phase detector 1, which is integrated into a DPLL circuitry, performs frequency detection and phase detection and comprises a first-in-first-out memory (FIFO) 101 with a bit depth of *L* = 128 bit, a read address counter 103 and a write address counter 102, a subtracter module 104, a phase sampling module 105 and two synchronization circuits 106 and 107. The subtracter module 104 thereby calculates a read/write address difference Dif-int0 which is representative of a digital signal Dif-int representing an integer part of the detected phase difference Δϕ, wherein Dif-int is given by the read/write address difference Dif-int0(6:0) := Waddr(6:0) - Raddr(6:0) after being sampled by a sampling clock signal Fmclk. The digital signal Dif-int representing the integer part of the detected phase difference Δϕ is then fed to the loop filter 2.

A digital signal Dif-frac representing the fractional part of the detected phase difference Δϕ, which is also fed to the loop filter 2, is given by the signal *Sum*(23:21), which represents the sum of accumulated phase values stored in the three most significant bits of the digital signal supplied by the phase accumulator 3. The loop filter 2 calculates, according to a method described in detail below, the input signal *K(x)* of the phase accumulator 3 based on a digital signal x represented by a function of two further digital signals Dif-int and Dif-frac representing the integer part and the fractional part of the detected phase difference Δϕ*,* respectively, and outputs the calculated data to the phase accumulator 3 which performs an accumulation procedure. The clock frequency of the phase sampling module 105 is the frequency of the clock signal Fmclk synchronized by a local high-speed crystal oscillator Clk58m. Thereby, Fmclk is a sampling clock signal which appears at a specific position of the frame head of each frame. The phase accumulator 3 accumulates the output signal *K*(*x*) of the loop filter 2 on each rising clock edge of the clock signal Clk58m supplied by the local high-speed crystal oscillator. The carry bit of addition is automatically overflowed, and the addition sum is stored to the register output variable *Sum*(23:0) on each rising clock edge of Clk58m. The accumulated phase values stored in the most significant bit *Sum*(23) of the digital signal supplied by the phase accumulator 3 thereby represents the local recovery clock signal Rclk.

The loop filter 2 implements an operational function for calculating the accumulated signal *K*(*x*) and adjusts the local recovery clock signal frequency *f*_{*rec*} at the output port of the phase accumulator 3. The operational method according to one aspect of the invention is as follows: First, an address difference reference offset *x*₀ representative of said phase difference reference value Δϕ_{*ref*} is set to half the bit depth *L* of the first-in-first-out (FIFO) memory 101 for defining a phase difference reference value Δϕ_{*ref*} representing a nominal value of the difference Δϕ between the phase ϕ_{*ref*} of the input clock signal Wclk and the phase ϕ_{*rec*} of the local recovery clock signal Rclk. In this embodiment, a FIFO with a bit depth L of 128 bit is applied, such that the address difference reference offset *x*₀ can be set to *x*₀ := *L* / 2 = 128 bit / 2 = 64 bit. Subtracter module 104 then calculates the phase difference Δϕ between the input clock signal phase ϕ_{*ref*} and the local recovery clock signal phase ϕ_{*rec*} according to the obtained output signal Waddr(6:0) of the write address counter 102 and the obtained output signal Raddr(6:0) of the read address counter 103, and the obtained calculation result Dif-intO, after being submitted to a sampling procedure with the clock signal Fmclk, is sent to the loop filter 2 as a digital signal Dif-int representing an integer part of the detected phase difference Δϕ. The write clock of the FIFO 101 is given by the input clock signal Wclk after being synchronized by the local high-speed crystal oscillator clock signal Clk58m, and the read clock of the FIFO 101 is given by the local recovery clock signal Rclk. The phase accumulator 3 outputs to said phase sampling module 105 a digital signal Dif-frac(2:0) constituted by the sum *Sum*(23:21) of the digital values stored in the three most significant bits of 24-bit register 302. The digital signal Dif-frac(2:0), after being submitted to a phase sampling procedure with clock signal Fmclk, is fed to the loop filter 2 as a fractional part of the phase difference representing signal x.

The loop filter 2 calculates the accumulated signal *K*(*x*) in segments according to a deviation of the detected phase difference Δϕ represented by the digital signal *x* (in bit) and a phase dif ference reference value Δϕ_{*ref*} represented by an address difference reference offset x₀ of 64 bit. When the deviation |*x* - *x*₀| is large, the accumulated signal *K*(*x*) follows *x* with a larger increment Δ*Km;* when said deviation is small, the accumulated signal *K*(*x*) follows *x* with a smaller increment Δ*Km*. The accumulated signal *K*(*x*) is then fed to the phase accumulator 3 for accumulation. Therefore, when |*x* - *x*₀| increases, the frequency of the local recovery clock signal Rclk, i.e. the most significant bit *Sum*(23)*,* is changed towards the nominal ideal frequency 2.048 MHz with a higher rate; otherwise, when |*x* - *x*₀| decreases, the frequency of the local recovery clock signal Rclk is changed towards the nominal ideal frequency 2.048 MHz with a lower rate.

According to one embodiment of the present invention, the loop filter 2 applies seven increments Δ*K*₁, Δ*K*₂*,* ..., Δ*K*₇ and four coefficients α₁, α₂*,* ... α₄ to an algorithm used for calculating the phase accumulator input signal *K*(*x*) according to the magnitude and the algebraic sign of a measured deviation (*x* - *x*₀) representing a deviation of the detected phase difference Δϕ from the phase difference reference value Δϕ_{*ref*}*,* wherein said algorithm is given by the following function: $K ( x ) : = {K}_{0} + Δ {S}_{m} ( x ) = {K}_{0} + {\sum }_{μ = 1}^{m} Δ {K}_{μ} ( x ) [ bit ] for m ∈ { 1 , 2 , … , 7 }$ with ${K}_{0} = K ( x = {x}_{0} ) [ bit ]$ and $Δ {S}_{m} ( x ) : = { \begin{matrix}- Δ x ⋅ {\sum }_{μ = 0}^{3 - m} {α}_{μ} - ( m ⋅ Δ x - x ) ⋅ {α}_{3 - m + 1} , & ( m - 1 ) ⋅ Δ x < x \leq m ⋅ Δ x , m ∈ { 1 , 2 , 3 } \\ ( x - {x}_{0} ) ⋅ {α}_{0} , & ( m - 1 ) ⋅ Δ x < x \leq ( m + 1 ) ⋅ Δ x , m = 4 \\ Δ x ⋅ {\sum }_{μ = 0}^{m - 5} {α}_{μ} + ( x - m ⋅ Δ x ) ⋅ {α}_{m - 5 + 1} , & m ⋅ Δ x < x \leq ( m + 1 ) ⋅ Δ x , m ∈ { 5 , 6 , 7 }\end{matrix} = { \begin{matrix}- 16 ⋅ {\sum }_{μ = 0}^{2} {α}_{μ} - ( 16 - x ) ⋅ {α}_{3} & for 0 < x \leq 16 \\ - 16 ⋅ {\sum }_{μ = 0}^{1} {α}_{μ} - ( 32 - x ) ⋅ {α}_{2} & for 16 < x \leq 32 \\ - 16 ⋅ {α}_{0} - ( 48 - x ) ⋅ {α}_{1} & for 32 < x \leq 48 \\ ( x - 64 ) ⋅ {α}_{0} & for 48 < x \leq 80 \\ 16 ⋅ {α}_{0} + ( x - 80 ) ⋅ {α}_{1} & for 80 < x \leq 96 \\ 16 ⋅ {\sum }_{μ = 0}^{1} {α}_{μ} + ( x - 96 ) ⋅ {α}_{2} & for 96 < x \leq 112 \\ 16 ⋅ {\sum }_{μ = 0}^{2} {α}_{μ} + ( x - 112 ) ⋅ {α}_{3} & for 112 < x \leq 128\end{matrix} [ bit ]$
with Δ*x* := 16 bit and *x*₀ := 4-Δ= 64 bit, wherein $x ( n ⋅ {T}_{s} ) : = {β}_{1} ⋅ {{Δ {A}_{W R} ( n ⋅ {T}_{s} )}_{︸}}_{= : Dif - int} + {β}_{2} ⋅ {{{\sum }_{\begin{matrix}l = {L}_{s} \\ ( {c}_{l} \neq 0 )\end{matrix}}^{{L}_{reg} - 1} K ( x ( ( n - ℓ ) ⋅ {T}_{s} ) ) ⋅ {c}_{l}^{- 1}}_{︸}}_{= : Dif - frac} + {x}_{0} [ bit ]$
with Δ*A*_{*wR*} (*n*·*T*_{*s*}) being address difference Dif-int0, β1, and β₂ being real-valued spreading factors used for spreading the obtained values for Dif-int and Dif-frac (here: β₁ = β₂ := 1), ${c}_{l} : = {b}_{l} ⋅ {2}^{l} ∀ l ∈ { 0 , 1 , 2 , … , {L}_{reg} - 1 }$
being the respective frequency divider coefficient given by the binary value ('0' or 1') stored in the *l*-th bit cell of register 302, which follows from the fact that a digital value represented by a bit sequence *B* := (*b*₀*, b*₁*, b*₂*, ..., b*₁*, ..., b*_{*Lreg*}) which is stored in said register 302 is representative of a sequence of frequency divider coefficients *c*_{*l*} which can be written in the form $C : = ( {c}_{0} , {c}_{1} , {c}_{2} , … , {c}_{l} , … , {c}_{{L}_{reg}} ) = ( {b}_{0} , {b}_{1} ⋅ {2}^{1} , {b}_{2} ⋅ {2}^{2} , … , {b}_{l} ⋅ {2}^{l} , … , {b}_{{L}_{reg}} ⋅ {2}^{{L}_{reg}} ) ,$
*L*_{*reg*} := 24 bit being the bit depth of register 302, *L*_{*s*} being the index of the *L*_{*s*}-th bit cell of said register 302, ${x}_{0} : = \frac{L}{2} [ bit ]$
being the address difference reference offset and, finally, L being the bit depth of first-in-first-out memory 101 denotes a digital signal being a function of two further digital signals Dif-int and Dif-frac which are representative of the integer part and the fractional part of the detected phase difference Δϕ, respectively, said function containing a shift of the obtained address difference signal by the address difference reference offset xo, *K*₀ is a digital reference value of the phase accumulator input signal *K*(*x*) supplied by the loop filter 2 when the detected phase difference Δϕ is equal to the phase difference reference value Δϕ_{*ref*}*, K*₀ being calculated dependent on the frequency *f*_{*rec*} of the local recovery clock signal Rclk, the frequency *f*_{*LO*} of the local crystal oscillator signal and the bit depth *L*_{*reg*} of register 302, which is obtained when *x* is equal to *x*₀, and *m* is the index of said increments Δ*K*_{*m*}*.* The accumulated input signal *K*(x) in each segment follows the detected phase difference Δϕ with a continuous, piecewise linear and strictly monotonously rising function, said function featuring the four segment slope factors α₀, α₁, α₂, and α₃ ∈ **R,** respectively, with α₀, α₁, α₂ and α₃ obeying the inequation ${α}_{0} < {α}_{1} < {α}_{2} < {α}_{3} .$

Thereby, said segment slope factors α₀, α₁, a and α₃ are respectively set to the following values: α₀ := 1, α₁ := 2, α₂ := 3, and α₃ := 4.

According to the above-described embodiment of the present invention, the phase accumulator input value *K*₀ supplied by loop filter 2 in case *x* is equal to *x*₀ is given by the following equation: ${K}_{0} : = ⌈ \frac{{f}_{rec}}{{f}_{L O}} ⋅ {2}^{{L}_{reg}} ⌉ = ⌈ \frac{2.048 MHz}{58.32 Mhz} ⌉ ⋅ {2}^{24} = 589 , 159.$

Due to the fact that in the above-described embodiment the bit depth *L* of FIFO 101 is 128 bit, *x* can take values from a range between 0 and 128 bit.

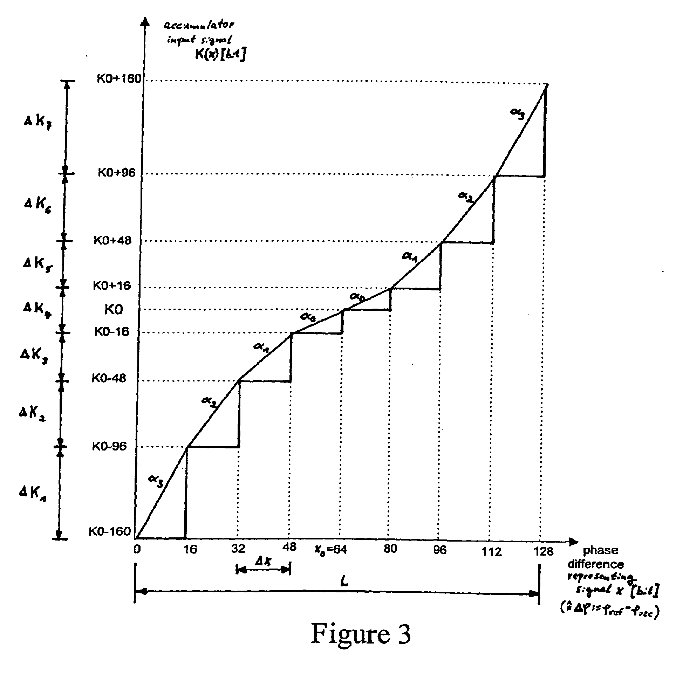

FIG. 3 shows that the above-mentioned accumulator input signal *K*(x) is a continuous, piecewise linear and strictly monotonously rising function of digital signal *x*. At segments where *x* deviates farthest from *x*₀ = 64 bit, such as at bit segments 0 < x ≤ 16 bit and 112 < x ≤ 128 bit having the steepest slope factor of all segments, the accumulated signal *K*(x) follows x with largest increments Δ*K*_{*m*}, from which it follows that the frequency *f*_{*rec*} of local recovery clock signal Rclk is adjusted to a nominal frequency given by the clock frequency *f*_{*ref*} = 2.048 MHz of input clock signal Wclk with fastest changing rate. At segments where x deviates largely from *x*₀ = 64 bit, such as at bit segments 16 < x ≤ 32 bit and 96 < x ≤ 112 bit, where the slope factors of the segments are relatively steep, the accumulated signal *K*(*x*) follows x with relatively large increments Δ*K*_{*m*}*,* compared with the increment values at other segments, which implies that *f*_{*rec*} is adjusted to *f*_{*ref*} = 2.048 MHz with a relatively fast changing rate. By contrast, at segments where x deviates less from *x*₀ = 64 bit, such as at bit segments 32 < x ≤ 48 bit and 80 < x ≤ 96 bit, where the slope factors of the segments are relatively small, the accumulated signal *K*(*x*) follows *x* with relatively small increments Δ*K*_{*m*}*,* compared with the increment values at other segments, which leads to the fact that *f*_{*rec*} is adjusted to *f*_{*ref*} = 2.048 MHz with a relatively slow changing rate. Finally, at the segment where the magnitude of the deviation (*x* - *x*₀) features a minimum, such as at bit segment 48 < x ≤ 80 bit having the smallest slope factor of all segments, the accumulated signal *K*(*x*) follows *x* with smallest increments Δ*K*_{*m*}, from which it follows that *f*_{*rec*} is adjusted to *f*_{*ref*} = 2.048 MHz with slowest changing rate. Thereby, *K*(*x*) is implemented without error code and, at the same time, vibration minimization is also concerned, such that DPLL vibration tolerance is better raised, vibration transfer characteristic is enhanced, and net output vibration indicators at low-band and high-band frequencies are improved. In the embodiment discussed above, when reference clock frequency is 20 Hz, vibration tolerance is given by 60 UI (units of issue) and vibration suppression characteristic is higher than -30 dB; when reference clock frequency is 2,018 kHz, net output vibration is less than 0.1 UI, and when reference clock frequency is 18,100 kHz, net output vibration is 0.035 UI in general.

## Claims

1. A method for controlling the phase (ϕ_{*LO*}) and stabilizing the output frequency *(f*_{*LO*}*)* of a local crystal oscillator clock signal (Clk58m) by means of a digital phase-locked loop (DPLL) frequency synthesizer circuitry, said method comprising the steps of
- defining a phase difference reference value (Δϕ_{*ref*}) representing a nominal value of the difference (Δϕ) between the phase (ϕ_{*ref*}) of an input clock signal (Wclk) and the phase (ϕ_{*rec*}) of a local recovery clock signal (Rclk) by setting an address difference reference offset (*x*₀) representative of said phase difference reference value (Δϕ_{*ref*}) to half the bit depth (L) of a the first-in-first-out memory (101),
- calculating a read/write address difference (Dif-int0) which denotes a bit position difference in a data stream of contents data between an input data pointer (P_{w}) and an output data pointer (P_{R}) indicating the starting addresses of contents data (Wdata) written to and contents data (Rdata) read from the first-in-first-out memory (101), respectively, said read/write address difference (Dif-int0) being representative of a detected phase difference (Δϕ) between the input clock signal (Wclk) and the local recovery clock signal (Rclk),
- comparing the detected phase difference (Δϕ) with the phase difference reference value (Δϕ_{*ref*}), and
- adjusting the local recovery clock signal (Rclk) in segments to the phase difference reference value (Δϕ_{*ref*}), wherein a correction signal (*K*(*x*)) used for adjusting the local recovery clock signal (Rclk), said correction signal (*K*(*x*)) being representative of a change in the detected phase difference (Δϕ)*,* is increased or decreased segment by segment depending on the magnitude and the algebraic sign of a detected deviation of the detected phase difference (Δϕ) from the phase difference reference value (Δϕ_{*ref*}),
***characterized in that***
***said correction signal (K(x)) is calculated based on a digital signal (x) which, compared with said read*/*write address difference (Dif-int0), is representative of a more precise representation of the detected phase difference (Δϕ), said digital signal (x) being a function of two further digital signals (Dif-int and Dif-frac) representing an integer part and a fractional part of the detected phase difference (Δϕ), respectively.***

2. ***The method according to claim 1,***
***characterized in that***
***the digital signal (Dif-int) representing the integer part of the detected phase difference (Δϕ) is given by the read*/*write address difference (Dif-int0) and the digital signal (Dif-frac) representing the fractional part of the detected phase difference (Δϕ) is given by a particular increment (ΔK***_{***m***}***) of said correction signal (K(x)) or by a partial sum of said increments (ΔK***_{***m***}***).***

3. The method according to claim 2,
**characterized in that**
the first-in-first-out memory (101) receives a write address signal (Waddr) and a read address signal (Raddr), the write address signal (Waddr) being a counter output value which is representative of the clock frequency of the input clock signal (Wclk) synchronized with a local crystal oscillator clock signal (Clk58m) and the read address signal (Raddr) being a further counter output value which is representative of the clock frequency (*f*_{*rec*}) of the local recovery clock signal (Rclk).

4. The method according to claim 3,
**characterized in that** the step of adjusting the local recovery clock signal (Rclk) in segments comprises the steps of
- sampling (105) the detected phase difference (Δϕ),
- calculating (2) increments (Δ*K*_{*m*}) of a phase accumulator input signal (*K*(*x*)) which is used for adjusting the phase (ϕ_{*rec*}) of the local recovery clock signal (Rclk) based on a deviation of a sampled time-domain signal representing the detected phase difference (Δϕ) from the phase difference reference value (Δϕ_{*ref*}) such that in case said deviation increases the step size of said increments is set to a larger value, whereas in case said deviation decreases the step size of said increments (Δ*K*_{*m*}) is set to a smaller value, said increments (Δ*K*_{*m*}) being a function of the sampled time-domain signal representing the detected phase difference (Δϕ),
- accumulating (301) said increments (Δ*K*_{*m*}), and
- calculating (302) said local recovery clock signal (Rclk) by controlling the divider coefficient of a digital frequency divider (302) used for dividing the frequency (*f*_{*LO*}) of the local crystal oscillator clock signal (Clk58m) such that in case said deviation increases an offset rate used for adjusting the phase (ϕ_{*rec*}) of the local recovery clock signal (Rclk) to the phase (ϕ_{*ref*}) of the input clock signal (Wclk) is set to a larger value, whereas in case said deviation decreases said offset rate is set to a smaller value, said offset rate being a cumulative function of digital signals which are representative of the frequency (*f*_{*LO*}) of said local crystal oscillator clock signal (Clk58m) divided by different divider coefficients stored in the digital frequency divider (302).

5. The method according to claim 4,
**characterized in that**
the steps of accumulating (301) said increments (Δ*K*_{*m*}) and calculating (302) said local recovery clock signal (Rclk) are performed by means of a phase accumulator (3) comprising an adder (301) and a register (302) supplied with a signal being representative of the frequency (*f*_{*LO*}) of the local crystal oscillator clock signal (Clk58m).

6. The method according to claim 5,
**characterized in that**
the step of sampling (105) the detected phase difference (Δϕ) is performed by means of a phase sampling module (105) supplied with a sampling clock signal (Fmclk) which is synchronized by the local crystal oscillator clock signal (Clk58m).

7. The method according to claim 6,
**characterized in that**
the phase accumulator input signal (*K*(*x*)) is a continuous, piecewise linear and strictly monotonously rising function of the digital signal (*x*) ***which is representative of the more precise representation of the detected phase difference (Δϕ).***

8. The method according to claim 7,
**characterized in that**
the bit depth (*L*) of the first-in-first-out memory (101) is given by 128 bit and the phase difference reference value (Δϕ_{ref}) is represented by an address difference reference offset (*x*₀) of 64 bit.

9. The method according to claim 8,
**characterized in that**
in the step of calculating (2) increments (Δ*K*_{*m*}) of a phase accumulator input signal (*K*(x)) seven increments (Δ*K*₁, Δ*K*₂, ..., Δ*K*₇) and four coefficients (α₁, α₂, ... α₄) are applied to an algorithm used for calculating the phase accumulator input signal (*K*(*x*)) according to the deviation of the sampled time-domain signal representing the detected phase difference (Δϕ) from the phase difference reference value (Δϕ_{*ref*}), wherein said algorithm is given by the following function: $K ( x ) : = {K}_{0} + Δ {S}_{m} ( x ) = {K}_{0} + {\sum }_{μ = 1}^{m} Δ {K}_{μ} ( x ) [ bit ] for m ∈ { 1 , 2 , … , 7 }$ with ${K}_{0} = K ( x = {x}_{0} ) [ bit ]$ and $Δ {S}_{m} ( x ) : = { \begin{matrix}- Δ x ⋅ {\sum }_{μ = 0}^{3 - m} {α}_{μ} - ( m ⋅ Δ x - x ) ⋅ {α}_{3 - m + 1} , & ( m - 1 ) ⋅ Δ x < x \leq m ⋅ Δ x , m ∈ { 1 , 2 , 3 } \\ ( x - {x}_{0} ) ⋅ {α}_{0} , & ( m - 1 ) ⋅ Δ x < x \leq ( m + 1 ) ⋅ Δ x , m = 4 \\ Δ x ⋅ {\sum }_{μ = 0}^{m - 5} {α}_{μ} + ( x - m ⋅ Δ x ) ⋅ {α}_{m - 5 + 1} , & m ⋅ Δ x < x \leq ( m + 1 ) ⋅ Δ x , m ∈ { 5 , 6 , 7 }\end{matrix} = { \begin{matrix}- 16 ⋅ {\sum }_{μ = 0}^{2} {α}_{μ} - ( 16 - x ) ⋅ {α}_{3} & for 0 < x \leq 16 \\ - 16 ⋅ {\sum }_{μ = 0}^{1} {α}_{μ} - ( 32 - x ) ⋅ {α}_{2} & for 16 < x \leq 32 \\ - 16 ⋅ {α}_{0} - ( 48 - x ) ⋅ {α}_{1} & for 32 < x \leq 48 \\ ( x - 64 ) ⋅ {α}_{0} & for 48 < x \leq 80 \\ 16 ⋅ {α}_{0} + ( x - 80 ) ⋅ {α}_{1} & for 80 < x \leq 96 \\ 16 ⋅ {\sum }_{μ = 0}^{1} {α}_{μ} + ( x - 96 ) ⋅ {α}_{2} & for 96 < x \leq 112 \\ 16 ⋅ {\sum }_{μ = 0}^{2} {α}_{μ} + ( x - 112 ) ⋅ {α}_{3} & for 112 < x \leq 128\end{matrix} [ bit ] ,$
Δ*x* := 16 bit and *x*₀ := 4·Δ*x* = 64 bit, wherein x (in bit) is a digital signal which is represented by a function of two further digital signals (Dif-int and Dif-frac) which are representative of the integer part and the fractional part of the detected phase difference (Δϕ), *K*₀ denotes a digital reference value of the phase accumulator input signal (*K*(*x*)) which is obtained when the detected phase difference (Δϕ) is equal to the phase difference reference value (Δϕ_{*ref*}), *K*₀ being calculated dependent on the frequency (*f*_{*rec*}) of the local recovery clock signal (Rclk), the frequency *(f*_{*LO*}*)* of the local crystal oscillator signal (Clk58m) and the bit depth *(L*_{*reg*}*)* of said register (302), and m is the index of said increments (Δ*K*_{*m*}), and wherein the accumulated input signal (*K*(*x*)) in each segment follows the detected phase difference (Δϕ) with a continuous, piecewise linear and strictly monotonously rising function, said function having the segment slope factors α₀, α₁*,* α_{*2*}*,* α_{*3*} ∈ R, respectively, with α₀, α₁*,* α₂ and α₃ obeying the inequation α₀ < α₁*,* < α_{*2*} < α₃*.*

10. The method according to claim 9,
**characterized in that**
said segment slope factors α₀, α₁*,* α₂ and α₃ are set to the following values: α₀ := 1, *α*₁ := 2, α_{*2*} := 3, and α₃ := 4.

## Patentansprüche

1. Verfahren zum Steuern der Phase (ϕ_{*LO*}) und Stabilisieren der Ausgabefrequenz *(f*_{*LO*}*)* eines lokalen Kristalloszillatortaktsignals (Clk58m) mittels einer Frequenzsynthesizerschaltung mit einer digitalen Phasenregelschleife (DPLL), wobei das Verfahren die Schritte umfasst
- Definieren eines Phasendifferenzreferenzwertes (Δϕ_{*ref*})*,* der einen Nominalwert der Differenz (Δϕ) zwischen der Phase *(*Δϕ_{*ref*}) eines Eingabetaktsignals (Wclk) und der Phase (ϕ_{*rec*}) eines lokalen Rückgewinnungstaktsignals (Rclk) repräsentiert, indem eine Adressdifferenzreferenzverschiebung (*x*₀)*,* die für Phasendifferenzreferenzwert (Δϕ_{*ref*}) repräsentativ ist, auf die Hälfte der Bittiefe (*L*) eines FIFO-Speichers (101) gesetzt wird,
- Berechnen einer Lese/Schreib-Adressdifferenz (Dif-int0), die eine Bitpositionsdifferenz in einem Datenstrom von Inhaltsdaten zwischen einem Eingabedatenzeiger (P_{W}) und einem Ausgabedatenzeiger (P_{R}), die jeweils die Startadressen von Inhaltsdaten (Wdata) die in den FIFO-Speichers (101) geschrieben, bzw. von Inhaltsdaten (Rdata), die aus ihm gelesen werden anzeigen, bezeichnen, wobei die Lese/Schreib-Adressdifferenz (Dif-int0) für eine detektierte Phasendifferenz (Δϕ) zwischen dem Eingabetaktsignal (Wclk) und dem lokalen Rückgewinnungstaktsignal (Rclk) repräsentativ ist,
- Vergleichen der detektierten Phasendifferenz (Δϕ) mit dem Phasendifferenzreferenzwert (Δϕ_{*ref*}), und
- Einstellen des lokalen Rückgewinnungstaktsignals (Rclk) in Segmenten auf den Phasendifferenzreferenzwert (Δϕ_{*ref*})*,* wobei ein zum Einstellen des lokalen Rückgewinnungstaktsignals (Rclk) verwendetes Korrektursignal (K(x)), das für eine Änderung in der detektierten Phasendifferenz (Δϕ) repräsentativ ist, Segment für Segment vergrößert oder verkleinert wird, abhängig von der Größe und dem Vorzeichen einer detektierten Abweichung der detektierten Phasendifferenz (Δϕ) von dem Phasendifferenzreferenzwert (Δϕ_{*ref*}),
**dadurch gekennzeichnet, dass**
das Korrektursignal (*K*(*x*)) basierend auf einem digitalen Signal (x) berechnet wird, das, verglichen mit der Lese/Schreib-Adressdifferenz (Dif-int0), für eine präzisere Repräsentation der detektierten Phasendifferenz (Δϕ) repräsentativ ist, wobei das digitale Signal (*x*) eine Funktion zweier weiterer digitaler Signale (Dif-int und Dif-frac) ist, die einen ganzzahligen Teil bzw. einen Bruchteil der detektierten Phasendifferenz (Δϕ) repräsentieren.

2. Verfahren gemäß Anspruch 1,
**dadurch gekennzeichnet, dass**
das digitale Signal (Dif-int), das den ganzzahligen Teil der detektierten Phasendifferenz (Δϕ) repräsentiert, durch die Lese/Schreib-Adressdifferenz (Dif-int0) gegeben ist, und das digitale Signal (Dif-frac), das den Bruchteil der detektierten Phasendifferenz (Δϕ) repräsentiert, durch einen besonderen Zuwachs (Δ*K*_{*m*}) des Korrektursignals *(K*(*x*)*)* oder durch eine Partialsumme der Zuwächse (Δ*K*_{*m*}) gegeben ist.

3. Verfahren gemäß Anspruch 2,
**dadurch gekennzeichnet, dass**
der FIFO-Speicher (101) ein Schreibadresssignal (Waddr) und ein Leseadresssignal (Raddr) empfängt, wobei das Schreibadresssignal (Waddr) ein Zählerausgabewert ist, der für die Taktfrequenz des Eingabetaktsignals (Wclk), synchronisiert mit einem lokalen Kristalloszillatortaktsignal (Clk58m), repräsentativ ist, und das Leseadresssignal (Raddr) ein weiterer Zählerausgabewert ist, der für die Taktfrequenz (*f*_{*rec*}) des lokalen Rückgewinnungstaktsignals (Rclk) repräsentativ ist.

4. Verfahren gemäß Anspruch 3,
**dadurch gekennzeichnet, dass** der Schritt des Einstellens des lokalen Rückgewinnungstaktsignals (Rclk) in Segmenten die Schritte umfasst:
- Abtasten (105) der detektierten Phasendifferenz (Δϕ),
- Berechnen (2) von Zuwächsen (Δ*K*_{*m*}) eines Phasenakkumulatoreingabesignals (*K*(*X*)), das verwendet wird, um die Phase (ϕ_{*rec*}) des lokalen Rückgewinnungstaktsignals (Rclk) basierend auf einer Abweichung eines abgetasteten Zeitbereichssignals, das die detektierte Phasendifferenz (Δϕ) repräsentiert, von dem Phasendifferenzreferenzwert (Δϕ_{*ref*}) derart einzustellen, dass in dem Fall, dass die Abweichung sich vergrößert, die Schrittgröße der Zuwächse auf einen größeren Wert gesetzt wird, während in dem Fall, dass die Abweichung sich verkleinert, die Schrittgröße der Zuwächse (Δ*K*_{*m*}) auf einen kleineren Wert gesetzt wird, wobei die Zuwächse (Δ*K*_{*m*}) eine Funktion des abgetasteten Zeitbereichssignals sind, das die detektierte Phasendifferenz (Δϕ) repräsentiert,
- Akkumulieren (301) der Zuwächse (Δ*K*_{*m*})*,* und
- Berechnen (302) des lokalen Rückgewinnungstaktsignals (Rclk) durch Steuern des Teilerkoeffizienten eines Digitalfrequenzteilers (302), der verwendet wird, um die Frequenz (*f*_{*LO*}) des lokalen Kristalloszillatortaktsignals (Clk58m) so zu teilen, dass in dem Fall, dass die Abweichung sich vergrößert, eine Verschiebungsrate, die verwendet wird, um die Phase (ϕ_{*rec*}) des lokalen Rückgewinnungstaktsignals (Rclk) auf die Phase (ϕ_{*ref*}) eines Eingabetaktsignals (Wclk) einzustellen, auf einen größeren Wert gesetzt wird, während dem Fall, dass die Abweichung sich verkleinert, die Verschiebungsrate auf einen kleineren Wert gesetzt wird, wobei die Verschiebungsrate eine kumulative Funktion digitaler Signale ist, die für die Frequenz (*f*_{*LO*}) des lokalen Kristalloszillatortaktsignals (Clk58m), geteilt durch verschiedene, in dem Digitalfrequenzteiler (302) gespeicherten Teilerkoeffizienten, repräsentativ sind.

5. Verfahren gemäß Anspruch 4,
**dadurch gekennzeichnet, dass**
die Schritte des Akkumulierens (301) der Zuwächse (Δ*K*_{*m*}) und des Berechnens (302) des lokalen Kristalloszillatortaktsignals (Clk58m) mittels eines Phasenakkumulators (3) durchgeführt werden, der einen Addierer (301) und ein Register (302) umfasst, das mit einem Signal, das für die Frequenz (*f*_{*LO*}) des lokalen Kristalloszillatortaktsignals (Clk58m) repräsentativ ist, gespeist wird.

6. Verfahren gemäß Anspruch 5,
**dadurch gekennzeichnet, dass**
der Schritt des Abtastens (105) der detektierten Phasendifferenz *(Δϕ)* mittels eines Phasenabtastmoduls (105) durchgeführt wird, das mit einem Abtasttaktsignal (Fmclk) gespeist wird, das durch das lokale Kristalloszillatortaktsignal (Clk58m) synchronisiert wird.

7. Verfahren gemäß Anspruch 6,
**dadurch gekennzeichnet, dass**
das Phasenakkumulatoreingabesignal (*K*(*x*)) eine kontinuierliche, gebietsweise lineare und streng monoton ansteigende Funktion des digitalen Signals (*x*) ist, das für die präzisere Repräsentation der detektierten Phasendifferenz (Δϕ) repräsentativ ist.

8. Verfahren gemäß Anspruch 7,
**dadurch gekennzeichnet, dass**
die Bittiefe (*L*) des FIFO-Speichers (101) durch 128 Bit gegeben ist, und der Phasendifferenzreferenzwert (Δϕ_{*ref*}) durch eine Adressdifferenzreferenzverschiebung (*x*_{*0*}) von 64 Bit repräsentiert wird.

9. Verfahren gemäß Anspruch 8,
**dadurch gekennzeichnet, dass**
bei dem Schritt des Berechnens (2) von Zuwächsen (Δ*K*_{*m*}) eines Phasenakkumulatoreingabesignals (*K*(*x*)) sieben Zuwächse (Δ*K*₁, Δ*K*₂*,...,* Δ*K*_{*7*}) und vier Koeffizienten (α₁, α₂,..., α₄) auf einen Algorithmus angewendet werden, der verwendet wird, um das Phasenakkumulatoreingabesignal (*K*(*x*)) gemäß der Abweichung des abgetasteten Zeitbereichssignals, das die detektierte Phasendifferenz (Δϕ) repräsentiert, von dem Phasendifferenzreferenzwert (Δϕ_{*ref*}) zu berechnen, wobei der Algorithmus durch die folgende Funktion gegeben ist: $K ( x ) : = {K}_{0} + Δ {S}_{m} ( x ) = {K}_{0} + {\sum }_{μ = 1}^{m} Δ {K}_{μ} ( x ) [ bit ] für m ∈ { 1 , 2 , … , 7 }$ *mit* ${K}_{0} = K ( x = {x}_{0} ) [ bit ]$ *und* $Δ {S}_{m} ( x ) : = { \begin{matrix}- Δ x ⋅ {\sum }_{μ = 0}^{3 - m} {α}_{μ} - ( m ⋅ Δ x - x ) ⋅ {α}_{3 - m + 1} , & ( m - 1 ) ⋅ Δ x < x \leq m ⋅ Δ x , m ∈ { 1 , 2 , 3 } \\ ( x - {x}_{0} ) ⋅ {α}_{0} , & ( m - 1 ) ⋅ Δ x < x \leq ( m + 1 ) ⋅ Δ x , m = 4 \\ Δ x ⋅ {\sum }_{μ = 0}^{m - 5} {α}_{μ} + ( x - m ⋅ Δ x ) ⋅ {α}_{m - 5 + 1} , & m ⋅ Δ x < x \leq ( m + 1 ) ⋅ Δ x , m ∈ { 5 , 6 , 7 }\end{matrix} = { \begin{matrix}- 16 ⋅ {\sum }_{μ = 0}^{2} {α}_{μ} - ( 16 - x ) ⋅ {α}_{3} & für 0 < x \leq 16 \\ - 16 ⋅ {\sum }_{μ = 0}^{1} {α}_{μ} - ( 32 - x ) ⋅ {α}_{2} & für 16 < x \leq 32 \\ - 16 ⋅ {α}_{0} - ( 48 - x ) ⋅ {α}_{1} & für 32 < x \leq 48 \\ ( x - 64 ) ⋅ {α}_{0} & für 48 < x \leq 80 \\ 16 ⋅ {α}_{0} + ( x - 80 ) ⋅ {α}_{1} & für 80 < x \leq 96 \\ 16 ⋅ {\sum }_{μ = 0}^{1} {α}_{μ} + ( x - 96 ) ⋅ {α}_{2} & für 96 < x \leq 112 \\ 16 ⋅ {\sum }_{μ = 0}^{2} {α}_{μ} + ( x - 112 ) ⋅ {α}_{3} & für 112 < x \leq 128\end{matrix} [ bit ] ,$
Δ*x :=* 16 Bit und *x*₀*:=* 4· Δ*x* = 64 Bit, wobei x (in bit) ein digitales Signal ist, das durch eine Funktion von zwei weiteren digitalen Signalen (Dif-int und Dif-frac), die für einen ganzzahligen Teil und einen Bruchteil der detektierten Phasendifferenz (Δϕ) repräsentativ sind, repräsentiert wird, *K*₀ bezeichnet einen digitalen Referenzwert des Phasenakkumulatoreingabesignals (*K*(*x*)), das erhalten wird, wenn die detektierte Phasendifferenz (Δϕ) gleich dem Phasendifferenzreferenzwert (Δϕ_{*ref*}) ist, wobei *K*_{*0*} abhängig von dem lokalen Rückgewinnungstaktsignal (Rclk), der Frequenz (*f*_{*LO*}) des lokalen Kristalloszillatortaktsignals (Clk58m) und der Bittiefe (*L*_{*reg*}) des Registers (302) berechnet wird, und *m* ist der Index der Zuwächse *(ΔK*_{*m*}), und wobei das akkumulierte Eingabesignal (*K*(*x*)) in jedem Segment der detektierten Phasendifferenz (Δϕ) mit einer kontinuierlichen, gebietsweise linearen und streng monoton ansteigenden Funktion folgt, wobei die Funktion jeweils die Segmentsteilheitsfaktoren α₀*,* α₁*,* α₂, α₃ ∈ R aufweist, wobei α₀, α₁, α₂ und α₃ die Ungleichung α₀ < α₁ < α₂ < α₃ erfüllen.

10. Verfahren gemäß Anspruch 9,
**dadurch gekennzeichnet, dass**
die Segmentsteilheitsfaktoren α₀*,* α₁*,* α₂ und α₃ auf die folgenden Werte gesetzt sind: α₀:= 1, α₁ := 2, α₂:= 3 und α₃:= 4.

## Revendications

1. Un procédé pour commander la phase (ϕ*LO*) et stabiliser la fréquence de sortie (*f*_{*LO*}) d'un signal d'horloge d'un oscillateur à cristal local (Clk58m) par le moyen d'un montage de synthétiseur de fréquences d'une boucle à verrouillage de phase numérique (DPLL), ledit procédé comprenant les étapes :
- de définition d'une valeur (Δϕ_{*ref*}) représentant une valeur nominale de la différence (Δϕ) entre la phase (ϕ_{*ref*}) d'un signal d'horloge d'entrée (Wclk) et la phase (ϕ_{*rec*}) d'un signal d'horloge de recouvrement local (Rclk), en réglant un décalage référence (*x*_{*0*}) de différence d'adresses, représentatif de ladite valeur référence de différence de phase (Δϕ_{*ref*}), à la moitié de la profondeur binaire (L) d'une mémoire premier entré premier sorti (101);
- de calcul d'une différence d'adresse de lecture/écriture (Dif-int0) qui dénote une différence de position binaire dans un flux de données de contenu entre un pointeur (P_{W}) de données d'entrée et un pointeur (P_{R}) de données de sortie indiquant les adresses initiales des données de contenu (Wdata) écrites dans la mémoire premier entré premier sorti (101) et des données de contenu (Rdata) lues depuis la mémoire premier entré premier sorti (101) respectivement, ladite différence d'adresse de lecture/écriture (Dif-int0) étant représentative d'une différence de phase détectée (Δϕ) entre le signal d'horloge d'entrée (Δϕ) et la valeur référence de différence de phase (Δϕ_{*ref*}) ;
- de comparaison de la différence de phase détectée (Rclk) et la valeur référence de différence de phase (Δϕ_{*ref*}) ; et
- d'ajustement en segments d'un signal d'horloge de recouvrement local (Rclk) à la valeur référence de différence de phase (Δϕ_{*ref*})*,* dans laquelle le signal de correction (*K*(*x*)) est utilisé pour ajuster le signal d'horloge de recouvrement local (Rclk), ledit signal de correction (*K*(*x*)), représentatif d'un changement dans la différence de phase détectée (Δϕ) est augmenté ou diminué segment par segment en fonction de l'amplitude et du signe algébrique d'une déviation détectée d'une différence de phase détectée (Δϕ) depuis la valeur référence de différence de phase (Δϕ_{*ref*}),
**caractérisé en ce que**
ledit signal de correction (*K*(*x*)) est calculé en se basant sur un signal numérique (*x*) qui, comparé à ladite différence d'adresse de lecture/écriture (Dif-int0), est représentatif d'une représentation plus précise de la différence de phase détectée (Δϕ), ledit signal numérique (*x*) étant une fonction de deux autres signaux numériques (Dif-int et Dif-frac) représentant une partie entière et une partie fractionnaire de la différence de phase détectée (Δϕ) respectivement.

2. Procédé selon la revendication 1, **caractérisé en ce que** le signal numérique (Dif-int) représentant la partie entière de la différence de phase détectée (Δϕ) est donnée par la différence d'adresse de lecture/écriture (Dif-int0) et **en ce que** le signal numérique (Dif-frac) représentant la partie fractionnaire de la différence de phase détectée (Δϕ) est donnée par un incrément particulier (Δ*K*_{*m*}) dudit signal de correction (*K*(*x*)) ou par une somme partielle desdits incréments (Δ*K*_{*m*}).

3. Procédé selon la revendication 2, **caractérisé en ce que** la mémoire premier entré premier sorti (101) reçoit un signal d'adresse d'écriture (Waddr) et un signal d'adresse de lecture (Raddr), le signal d'adresse d'écriture (Wadrr) étant une valeur de sortie de compteur qui est représentative d'une fréquence d'horloge d'un signal d'horloge d'entrée (Wclk) synchronisé avec un signal d'horloge d'un oscillateur à cristal local (Clk58m) et le signal d'adresse de lecture (Raddr) étant une autre valeur de sortie de compteur qui est représentative de la fréquence d'horloge (*f*_{*rec*}) d'un signal d'horloge de recouvrement local (Rclk).

4. Procédé selon la revendication 3,
**caractérisé en ce que** l'étape d'ajustement en segments du signal d'horloge de recouvrement local (Rclk) comprend les étapes
- d'échantillonnage (105) de la différence de phase détectée *(*Δϕ)
- de calcul (2) des incréments (Δ*K*_{*m*}) d'un signal d'entrée d'accumulateur de phase (*K*(*x*)) qui est utilisé pour ajuster la phase (ϕ_{*rec*}) du signal d'horloge de recouvrement local (Rclk) basé sur une déviation d'un signal échantillonné dans le domaine temporel représentant la différence de phase détectée (Δϕ) depuis la valeur référence de différence de phase (Δϕ_{*ref*}) de sorte que dans le cas où ladite déviation augmente, la grandeur de pas desdits incréments (Δ*K*_{*m*}) est mise à une plus grande valeur, alors que dans le cas où ladite déviation décroît, la grandeur de pas desdits incréments (Δ*K*_{*m*}) est mise à une plus petite valeur, lesdits incréments (Δ*K*_{*m*}) étant fonction du signal échantillonné dans le domaine temporel représentant la différence de phase détectée (Δϕ)*,*
- d'accumulation (301) desdits incréments (Δ*K*_{*m*}), et
- de calcul (302) dudit signal d'horloge de recouvrement local (Rclk) en commandant le coefficient diviseur d'un diviseur de fréquence numérique (302) utilisé pour diviser la fréquence (*f*_{*LO*}) du signal d'horloge d'oscillateur à cristal local (Clk58m) de sorte que dans le cas où ladite déviation augmente, une cadence de décalage, utilisée pour ajuster la phase (ϕ_{*rec*}) du signal d'horloge de recouvrement local (Rclk) à la phase (ϕ_{*ref*}) du signal d'horloge d'entrée (Wclk), est mise à une plus grande valeur, alors que dans le cas où ladite déviation décroît, ladite cadence de décalage est mise à une plus petite valeur, ladite cadence de décalage étant une fonction cumulative des signaux numériques qui sont représentatifs de la fréquence (*f*_{*LO*}) dudit signal d'horloge d'oscillateur à cristal local (Clk58m) divisé par différents coefficients diviseurs stockés dans le diviseur de fréquence numérique (302).

5. Procédé selon la revendication 4,
**caractérisé en ce que**
les étapes d'accumulation (301) desdits incréments (Δ*K*_{*m*}) et de calcul (302) dudit signal d'horloge de recouvrement local (Rclk) sont exécutées par le moyen d'un accumulateur de phase (3) comprenant un additionneur (301) et un registre (302) fourni avec un signal étant représentatif de la fréquence (*f*_{*LO*}) du signal d'horloge d'oscillateur à cristal local (Clk58m).

6. cédé selon la revendication 5,
**caractérisé en ce que**
l'étape d'échantillonnage (105) de la différence de phase détectée (Δϕ) est exécutée par le moyen d'un module d'échantillonnage de phase (105) fourni avec un signal d'horloge échantillonné (Fmclk) qui est synchronisé par le signal d'horloge d'oscillateur à cristal local (Clk58m).

7. Procédé selon la revendication 6,
**caractérisé en ce que**
le signal d'entrée d'accumulateur de phase (105) est une fonction continue, linéaire par morceaux, et croissante de façon strictement monotone du signal numérique (*x*) qui est représentative de la représentation la plus précise de la différence de phase détectée (Δϕ).

8. Procédé selon la revendication 7,
**caractérisé en ce que**
la profondeur binaire (L) de la mémoire premier entré premier sorti (101) est donnée par 128 bits et la valeur référence de la différence de phase (Δϕ_{*ref*}) est représentée par un décalage référence de différence d'adresses (x_{*0*}) de 64 bits.

9. Procédé selon la revendication 8,
**caractérisé en ce que**
dans l'étape de calcul (2) des incréments *(*Δ*K*_{*m*}) d'un signal d'entrée d'un accumulateur de phase (K(x)), sept incréments (Δ*K*_{*1*}*,* Δ*K*_{*2*}*,* ..., Δ*K*_{*7*}) et quatre coefficients (α_{*1*}*,* α_{*2*}*,* ..., α_{*4*}) sont appliqués à un algorithme utilisé pour calculer le signal d'entrée d'accumulateur de phase (*K*(*x*)) selon la déviation du signal échantillonné dans le domaine temporel représentant la différence de phase détectée (Δϕ) depuis la valeur référence de différence de phase (Δϕ_{*ref*}), dans lequel ledit algorithme est donné par la fonction suivante : $K ( x ) : = {K}_{0} + Δ {S}_{m} ( x ) = {K}_{0} + {\sum }_{μ = 1}^{m} Δ {K}_{μ} ( x ) [ bit ] pour m ∈ { 1 , 2 , … , 7 }$ avec ${K}_{0} = K ( x = {x}_{0} ) [ bit ]$ et $Δ {S}_{m} ( x ) : = { \begin{matrix}- Δ x ⋅ {\sum }_{μ = 0}^{3 - m} {α}_{μ} - ( m ⋅ Δ x - x ) ⋅ {α}_{3 - m + 1} , & ( m - 1 ) ⋅ Δ x < x \leq m ⋅ Δ x , m ∈ { 1 , 2 , 3 } \\ ( x - {x}_{0} ) ⋅ {α}_{0} , & ( m - 1 ) ⋅ Δ x < x \leq ( m + 1 ) ⋅ Δ x , m = 4 \\ Δ x ⋅ {\sum }_{μ = 0}^{m - 5} {α}_{μ} + ( x - m ⋅ Δ x ) ⋅ {α}_{m - 5 + 1} , & m ⋅ Δ x < x \leq ( m + 1 ) ⋅ Δ x , m ∈ { 5 , 6 , 7 }\end{matrix} = { \begin{matrix}- 16 ⋅ {\sum }_{μ = 0}^{2} {α}_{μ} - ( 16 - x ) ⋅ {α}_{3} & pour 0 < x \leq 16 \\ - 16 ⋅ {\sum }_{μ = 0}^{1} {α}_{μ} - ( 32 - x ) ⋅ {α}_{2} & pour 16 < x \leq 32 \\ - 16 ⋅ {α}_{0} - ( 48 - x ) ⋅ {α}_{1} & pour 32 < x \leq 48 \\ ( x - 64 ) ⋅ {α}_{0} & pour 48 < x \leq 80 \\ 16 ⋅ {α}_{0} + ( x - 80 ) ⋅ {α}_{1} & pour 80 < x \leq 96 \\ 16 ⋅ {\sum }_{μ = 0}^{1} {α}_{μ} + ( x - 96 ) ⋅ {α}_{2} & pour 96 < x \leq 112 \\ 16 ⋅ {\sum }_{μ = 0}^{2} {α}_{μ} + ( x - 112 ) ⋅ {α}_{3} & pour 112 < x \leq 128\end{matrix} [ bit ] ,$
Δx = 16 bits et *x*₀ = 4*Δ*x* = 64 bits, où *x* (en bits) est un signal numérique qui est représenté par une fonction de deux autres signaux numériques (Dif-int et Dif-frac) qui sont représentatifs de la partie entière et de la partie fractionnaire de la différence de phase détectée (Δϕ), *K*_{*0*} dénote une valeur référence numérique du signal d'entrée d'accumulateur de phase (*K*(*x*)) qui est obtenu lorsque la différence de phase détectée (Δϕ) est égale à la valeur référence de différence de phase (Δϕ_{*ref*}), *K*_{*0*} étant calculé en fonction de la fréquence (*f*_{*rec*}) du signal d'horloge de recouvrement local (Rclk), la fréquence (*f*_{*LO*}) du signal d'oscillateur à cristal local (Clk58m) et la profondeur binaire (*L*_{*reg*}) dudit registre (302), et m est l'index desdits incréments (ΔKₘ), et dans lequel le signal d'entrée accumulé (*K*(*x*)) dans chaque segment suit la différence de phase détectée (Δϕ) par une fonction continue, linéaire par morceaux, et croissante de manière strictement monotone, ladite fonction ayant des facteurs de pentes de segments α_{*1*}*,* α_{*2*}*,* α_{*3*}*,* α_{*4*} ∈ R respectivement, avec α_{*0*}*,* α_{*1*}*,* α_{*2*}*,* et α₃, obéissant à l'équation α_{*0*}*<*α_{*1*}*<*α_{*2*}*<*α_{*3*}*.*

10. Procédé selon la revendication 9,
**caractérisé en ce que**
lesdits facteurs de pentes de segments α_{*0*}*,* α_{*1*}*,* α_{*2*}*,* et α_{*3*} sont mis aux valeurs α_{*0*} = 1, α_{*1*} = 2*,* α_{*2*} = 3 et α_{*3*} = 4.
